# EUROPEAN PATENT APPLICATION

(11) **EP 3 869 554 A1**
(43) Date of publication of application: **25.08.2021**
(21) Application number: 18939519.7
(22) Date of filing: 09.11.2018
(51) Int. Cl.: H01L 23/525

(54) **CHIP INTEGRATED WITH AT LEAST TWO DIES**

(71) Applicant: Huawei Technologies Co., Ltd., Longgang District Shenzhen, Guangdong 518129 (CN)
(72) Inventor: GU, Shiqun, San Diego, California 92121 (US); XIA, Yu, Shenzhen, Guangdong 518129 (CN)
(74) Representative: Gill Jennings & Every LLP
(86) International application number: PCT/CN2018/114890
(87) International publication number: WO 2020/093391

(57) **Abstract**

A chip (100) is provided, and includes a first die (110) and a second die (130). The second die (130) is disposed on the first die (110). A filling dielectric layer (140) is further disposed in the chip (100). A through dielectric via (Through Dielectric Via) (150) and an interconnection metal (160) are disposed in the filling dielectric layer (140), and the first die (110) is coupled to the second die (130) through the through dielectric via (150) and the interconnection metal (160). According to the chip (100), a plane area of the chip (100) can be reduced, and manufacturing costs are relatively low.

## Description

### TECHNICAL FIELD

The present invention relates to the field of integrated circuits, and in particular, to a chip integrated with at least two dies.

### BACKGROUND

Since 2000, mobile terminals have been developed rapidly. Especially, smartphones have integrated functions of multimedia, Internet, games, and network platforms, and performance of the smartphones has been improved year by year at extremely high speeds. Inside a mobile terminal, a chip is like a brain or a heart, and a processing rate, power consumption, and even a volume and costs of the mobile terminal are affected by the chip. In 2018, with the release of new-generation processor chips from various manufacturers, a chip technology has also entered the 7 nm process era. However, an overall size of the chip has not decreased significantly due to the improvement of process integration. Even, as performance requirements increase, there is a pressure of an increase in a size of the processor chip. However, the mobile terminal needs to accommodate more new types of chips or electronic components. This leads to increasingly tight carrier space of the mobile terminal device. To resolve the problem of insufficient carrier space, terminal manufacturers usually choose to sacrifice the appearance of the product to provide more carrier space. In the field of mobile terminals, it is often seen that a phone product is close to a tablet in appearance and size or has a strange-looking large jaw. This may be a concession for more carrier space. Technologies that can reduce a plane size of the chip have always been the focus in the industry.

### SUMMARY

The present invention provides a chip integrated with a plurality of dies, so that a plane size of the chip can be reduced by placing the dies in stack.

To achieve the foregoing objective, the present invention uses the following solutions.

The present invention provides a chip, including a first die and a second die. The second die is disposed on the first die; and a filling dielectric layer is further disposed in the chip. Athrough dielectric via (Through Dielectric Via) and an interconnection metal are disposed in the filling dielectric layer, and the first die is coupled to the second die through the through dielectric via and the interconnection metal.

Two dies are integrated in the chip provided in the present invention, and the two dies are stacked up and down. Functional circuits to be carried in the chip are distributed to the dies stacked up and down, thereby reducing the plane size of the chip.

In addition, optionally, a filling dielectric in the filling dielectric layer wraps the first die. The filling dielectric may also wrap the second die or cover a top of the second die. The first chip and the second chip are coupled through the through dielectric via and the interconnection metal that are disposed in the filling dielectric. Because the through dielectric via passes through only the filling dielectric and does not need to pass through a Si substrate, costs are lower than those of a Si channel technology that is more commonly used in the conventional technology.

The first die and the second die are placed in stack, where tops of the two dies both face a bottom of the chip. In this way, a signal transmission path between a functional circuit near a top of the chip and outside of the chip can be shortened. In addition, the first die and the second die in the present invention.

Optionally, the first die and the second die may carry different functional circuits. Power consumption of a circuit carried by the first die is higher than power consumption of the second die. In this way, the first die is closer to the bottom of the chip. In an electronic device, heat generated when a chip works is usually dissipated to outside of the electronic device through a carrier of the electronic device, and a first die close to the bottom of the chip has a better heat dissipation condition, and therefore is more suitable for carrying a circuit with high power consumption. In the electronic device, a processor usually has highest power consumption. Therefore, the first die is suitable for carrying a circuit of various processors such as a CPU and a GPU, and the second die may be used to carry an input/output circuit and/or an analog circuit with generally lower power consumption.

Optionally, the chip provided in the present invention may be integrated with a plurality of first dies, a plurality of second dies, or even a plurality of first dies and second dies. Circuits carried in the plurality of first dies may be different, and circuits in the plurality of second dies may also be different. In the present invention, the first die and the second die are distinguished by positions. For example, in the chip, a chip close to the bottom of the chip is the first die, and a chip away from the bottom is the first die. In the foregoing description, two layers of dies are integrated in the chip. A die on a layer close to the bottom of the chip is the first die, and a die on a layer away from the bottom of the chip is the second die. Further, three or more layers of dies may be integrated in the chip. For every two layers of adjacent dies, a die close to the bottom of the chip is the first die, and a die away from the bottom of the chip is the second die.

Generally, the first die and the second die each include a Si substrate and a metal interconnect layer. A transistor is formed on the Si substrate, and the metal interconnect layer is used to carry a circuit. One side close to the metal interconnect layer is the top of the die, and one side close to the Si substrate is the bottom of the die.

Optionally, a circuit layer wrapped by an insulating dielectric is disposed in the metal interconnect layer, and the circuit layer is coupled to the Si substrate or the through dielectric via through a via in the insulating dielectric. The metal interconnect layer may include at least two circuit layers, and when the metal interconnect layer includes at least two circuit layers, the at least two circuit layers are also coupled through the via. Optionally, a layer closest to a top surface of the first die or the second die in the at least two circuit layers is coupled to the through dielectric via through the via.

### BRIEF DESCRIPTION OF DRAWINGS

To describe the technical solutions in the embodiments of the present invention more clearly, the following briefly describes the accompanying drawings for describing the embodiments of the present invention. It is clear that, the accompanying drawings in the following description show merely some embodiments of the present invention, and persons of ordinary skill in the art may derive other drawings from these accompanying drawings without creative efforts.
FIG. 1 is a schematic diagram of packaging a chip by using a package on package technology;
FIG. 2 is a schematic diagram of a chip according to an embodiment of the present invention;
FIG. 3 is a schematic diagram of a further package structure of a chip according to an embodiment of the present invention;
FIG. 4 is a schematic diagram of a chip package structure according to another embodiment of the present invention; and
FIG. 5 is a schematic diagram of a chip package structure according to still another embodiment of the present invention.

### DESCRIPTION OF EMBODIMENTS

To make the objectives, technical solutions, and advantages of the embodiments of the present invention clearer, the following further describes the embodiments of the present invention with reference to the accompanying drawings.

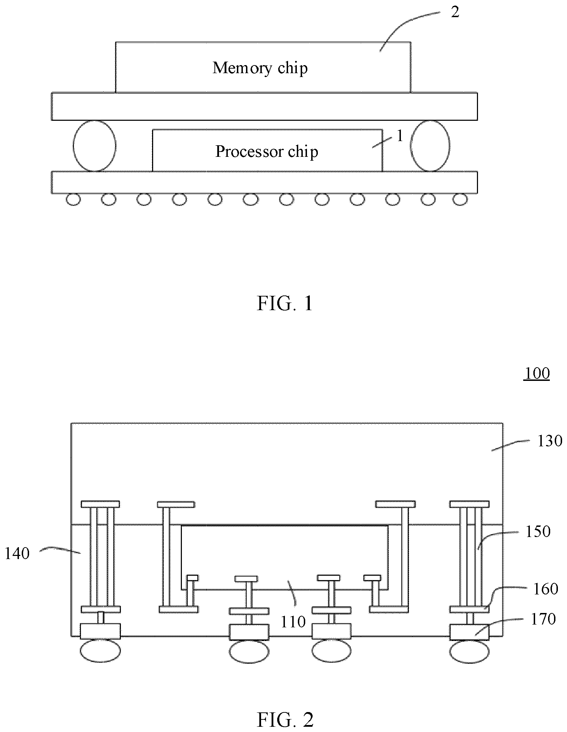

In a terminal device, data is processed by using a processor chip, and data is stored by using a memory chip. Because the processor chip needs to use data in the memory chip, to improve a processing rate, a packaging solution shown in FIG. 1 is proposed in the industry. A processor chip 1 and a memory chip 2 are packaged together by using a package on package (Package on Package, POP for short) technology. The processor chip 1 and the memory chip 2 each are disposed on a substrate, and then the substrates of the processor chip 1 and the memory chip 2 are fastened together by using a solder ball. Currently, the POP has been widely applied to package of a processor chip of a mobile terminal.

The POP is a chip-level packaging solution, and focuses on packaging a plurality of chip entities into a physical entity to improve data transmission efficiency and stability of an entire system. In the integrated circuit industry, a "chip" is a relatively broad concept. The processor chip 1 and the memory chip 2 shown in FIG. 1 may each be considered as a chip, and an object entity formed by the two is a "chip" finally presented to a terminal user. A difference is that: A core part of the physical entity in FIG. 1 is formed by two chips, and a core part of the processor chip 1 or the memory chip 2 is a die (Die). The die is usually disposed with only solder joints for packaging, and cannot be directly used in an electronic device. In addition, the die is very susceptible to the temperature, impurities, and physical forces of an external environment, and is easily damaged. Therefore, the die can be used in the electronic device only after being sealed in a closed space to lead out corresponding pins.

The die is usually formed by a Si substrate (Si substrate) and a metal interconnect layer (Metal Layer Interconnect) that are sealed. A transistor is formed on the Si substrate, a plurality of circuit layers are disposed in the metal interconnect layer, and the plurality of circuit layers are wrapped by an insulating dielectric. The plurality of circuit layers include various active circuits and passive circuits. A via (Via) is disposed in the insulating dielectric in the metal interconnect layer, and the via is plated with copper or filled with a copper post. The via is used to couple circuits on different circuit layers, or couple circuits on the circuit layers to the transistor on the Si substrate.

Based on the foregoing content, an embodiment of the present invention provides a chip 100. As shown in FIG. 2, the chip 100 is a chip obtained by packaging dies, and includes at least two dies that are packaged together: a first die 110 and a second die 130. The first die 110 and the second die 130 are placed in stack. In this embodiment of the present invention, the second die 130 is disposed on a top of the first die 110. In this embodiment of the present invention, the chip 100 is packaged with two dies, and essentially, a circuit in a processor chip that is supposed to be placed in one die is split into two dies. A splitting principle may be set based on a requirement. For example, the dies in the processor chip shown in FIG. 1 are determined based on power consumption, where one die carries a circuit with high power consumption, and the other die carries a circuit with low power consumption. Alternatively, one die in the processor chip is split into two dies based on a power domain, and circuits in a same power domain or having control and management logic of a similar power domain are disposed in a same die. Alternatively, circuits are distinguished based on correlation between functions or signal transmission between circuits, and circuits with high correlation are disposed in a same die. Certainly, the die may also be randomly split only based on the circuit layout.

Splitting a die that is supposed to be one into two dies and placing the two dies in stack can reduce a plane area of the chip, and reduce a plane size of the chip, thereby reducing an area occupied by the chip on a carrier of the electronic device.

Further, a filling dielectric layer 140 is disposed in the chip 100 provided in this embodiment of the present invention. A filling dielectric in the filling dielectric layer 140 wraps the first die 110. In an optional embodiment, the filling dielectric layer further wraps the second die 130. The filling dielectric layer is made of an insulating material, usually Si02, which isolates the first die 110 and the second die 130 from the external environment and provides proper stress support for the entire physical structure to prevent deformation. In FIG. 2, a plane area of the first die 110 is smaller than a plane area of the second die 130. Therefore, it can be seen that the filling dielectric layer 140 completely wraps the first die 110 and partially wraps the second die 130. In an actual product, the filling dielectric 140 may wrap a part of or all surfaces of the second die 130 as required.

A through dielectric via (Through Dielectric Via, TDV for short) 150 and an interconnection metal 160 are disposed in the filling dielectric layer 140. The TDV 150 is formed by perforating in the filling dielectric layer 140 vertically and then plating the via with a metal or filling the via with a metal post, and is used to provide a vertical signal path in the filling dielectric 140. The interconnection metal 160 is a metal line disposed in the filling dielectric layer 140, and is used to provide a horizontal signal path in the filling dielectric layer 140. The filling dielectric layer 140 is usually obtained by growing through chemical deposition. In this way, when the filling dielectric layer 140 grows to a proper depth, the TDV 150 is made by perforating in the grown filling dielectric layer 140, and the interconnection metal 160 is disposed on a surface of the grown filling dielectric layer 140. Therefore, although theoretically starting points of the interconnection metal 160 and the TDV 150 may be at different depths of the filling dielectric layer 140, process costs are lowest if all starting points of the interconnection metal 160 and the TDV 150 are set at a same depth of the filling dielectric layer 140. It should be noted that a plurality of interconnection metals 160 may be disposed in the filling dielectric 140, and the plurality of interconnection metals 160 are separated from each other by the filling dielectric. The plurality of interconnection metals 160 may be generated together at the same depth of the filling dielectric layer 140, or certainly, a plurality of depths in the filling dielectric layer 140 may be selected to dispose the interconnection metal 160. In an optional embodiment, the TDV 150 has an aperture of about 5 to 10 microns (um).

It can be seen from FIG. 2 that the TDV 150 includes two types: a first TDV directly coupled to the first die 110, and a second TDV directly coupled to the second die 130. When the first TDV and the second TDV are coupled to a same interconnection metal 160, the first die 110 and the second die 130 are coupled to the interconnection metal through the first TDV and the second TDV In other words, the first TDV, the second TDV, and the interconnection metal 160 establish a signal path in the filling dielectric layer 140 for the first die 110 and the second die 130.

In this embodiment of the present invention, data communication between the first die 110 and the second die 130 depends on a data channel disposed in the filling dielectric layer 140. The data channel does not need to pass through the first die 110 or the second die 130. In other words, the Si substrate does not need to be perforated. Compared with a through silicon via (Through Silicon Via, TSV for short) technology commonly used in the conventional technology, costs of perforating only in the filling dielectric are significantly lower.

Still referring to FIG. 2, a pad (Pad) 170 is disposed on a bottom surface of the filling dielectric layer 140, and the pad 170 serves as an external information interface or a power supply interface of the first die 110 and the second die 130. The pad 170 is disposed at a bottom of the chip 100, and the first die 110 is located between the first die 130 and the pad 170. The TDV 150 further includes a third TDV for coupling the pad 170 and a part of the interconnection metal 160. The pad 170 transmits a signal to the first die 110 and the second die 130 through the TDV 150 and the interconnection metal.

As mentioned above, a circuit separately carried in the first die 110 or the second die 130 may be allocated based on power consumption of the circuit. In an optional embodiment, the first die 110 carries a circuit with high power consumption, and the second die 130 carries a circuit with low power consumption. Specifically, the circuit with high power consumption may include various types of processors such as a central processing unit (Central Processing Unit, CPU for short) and a graphics processing unit (Graphics Processing Unit, GPU for short). The circuit with low power consumption may be an input/output circuit (Input/Output Circuit, I/O circuit for short), various analog circuits, or the like.

The processor has a relatively high requirement for power supply in a working or operation process. A position of the first die 110 is closer to the pad 170. In other words, the first die 110 is closer to a substrate for carrying the chip 100, and therefore has a shorter power supply path. The shorter power supply path causes a smaller power supply loss and interference, and therefore the first die 110 has higher power supply quality than the second die 130. In addition, the circuit with high power consumption generates more heat, and the circuit with high power consumption is disposed in the die 110 closer to the substrate. This facilitates heat dissipation through the substrate.

In an optional embodiment, the first die 110 and the second die 130 may use different manufacture precision. Currently, the manufacture precision is generally measured in nanometers (nm). Using the processor chip of the mobile terminal as an example, 14 nm manufacture precision was widely used in the processor chip before, and 7 nm manufacture precision has been used in the processor chip of the mobile terminal in 2018. Generally, chip performance develops by leaps and bounds with the improvement of the manufacture precision. However, an integrated circuit in a chip with high manufacture precision has a lower voltage tolerance capability. Currently, power supply voltages of 1.8 V and 3 V are widely used in the processor chip of the mobile terminal. However, it is found that the integrated circuit with 5 nm manufacture precision cannot support the voltages of 1.8 V and 3 V. Therefore, based on the design that the chip 100 has two dies in this embodiment of the present invention, the first die 110 and the second die 130 may use different manufacture precision, where a die with lower manufacture precision is used to carry a circuit that has a high voltage requirement, and a die with higher manufacture precision is used to carry a circuit with a low voltage requirement. This method can resolve the contradiction between the manufacture precision and the voltage required by the integrated circuit.

Generally, a circuit such as a processor needs high manufacture precision to provide more functions and higher performance. Therefore, generally, a die with high manufacture precision is a die with high power consumption, such as the foregoing first die for carrying various processor circuits. A circuit whose voltage requirement exceeds a voltage threshold that can be supported by the process precision is placed into a die with low manufacture precision.

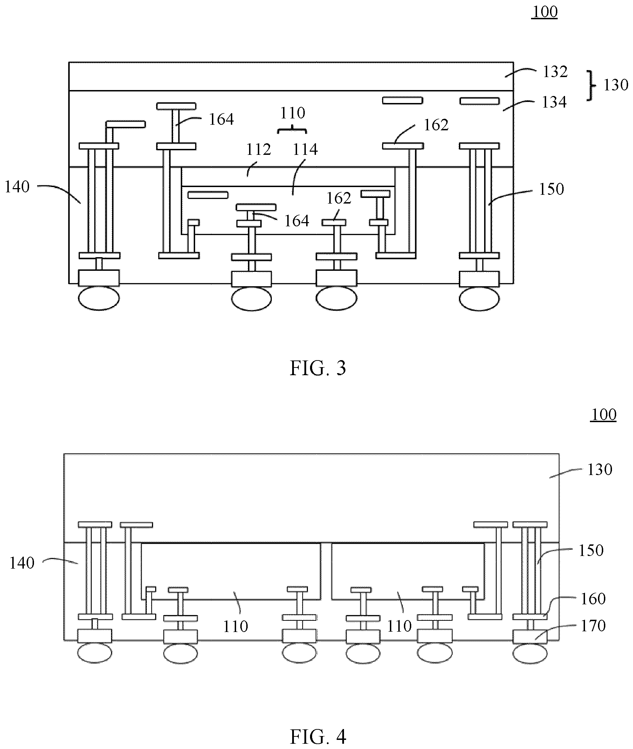

In an optional embodiment, FIG. 3 provides a further schematic diagram of the chip 100 according to an embodiment of the present invention. As shown in FIG. 3, the first die 110 includes a first Si substrate 112 and a first metal interconnect layer 114 carried on the first Si substrate 112; and the second die 130 includes a second Si substrate 132 and a second metal interconnect layer 134 carried on the Si substrate 132. A transistor is formed on tops (one side near the first metal interconnect layer 114 or the second metal interconnect layer 134) of the first Si substrate 112 and the second Si substrate 132. The first Si substrate 112 and the first metal interconnect layer 114, the second Si substrate 132 and the second metal interconnect layer 134, and the first Si substrate 112 and the second metal interconnect layer 134 are fixed together by using an "Oxide to Si Bond" (Oxide to Si Bond) or "Oxide to Oxide Bond" (Oxide to Oxide Bond) process.

The embodiment in FIG. 3 describes a structure of the die of the chip 100 in this embodiment of the present invention. It can be seen that the die includes two parts: a Si substrate and a metal interconnect layer, and the first Si substrate 112 of the first die 110 is attached to the second metal interconnect layer 134 of the second die 130. In the industry, one side of the metal interconnect layer in the die is generally referred to as a top (also referred to as a face, face), and one side of the Si substrate of the die is referred to as a bottom (which may also be referred to as a back, back). In other words, the first die and the second die are in a "face to back" stacking (Face to Back Stacking) manner. In this stacking manner, the Si substrate of the first die 110 and the second die 130, layout directions of the metal interconnect layer and the Si substrate of the first die 110 and the second die 130 are consistent, or arrangement directions of the top and the bottom are consistent. Then, in the chip 100, the first die 110 and the second die 130 are essentially in an inverted manner, so that the tops of the two dies are closer to the bottom of the chip 100 than the bottoms of the two dies, or so that the metal interconnect layers of the two dies are closer to the pad 170 of the chip 100 than the Si substrate. In this manner, a length of a path for receiving a signal (including power supply) by various circuits in the metal interconnect layer can be minimized, thereby further ensuring signal quality.

A circuit layer 162 and an insulating dielectric wrapping the plurality of circuit layers are disposed in the first metal interconnect layer 114 and the second metal interconnect layer 134. Generally, at least two circuit layers 162 are disposed in the first metal interconnect layer 114 and the second metal interconnect layer 134. The circuit layer 162 is formed in a manner similar to the interconnection metal 160 in FIG. 1. In a growth process of the insulating dielectric, copper is plated on a surface of the insulating dielectric to lay the circuit layer 162. A via 164 is disposed in the insulating dielectric, and the via is plated with copper or filled with a copper post. The circuit layer 162 is coupled to the Si substrate or the TDV 150 through the via 164. Specifically, the circuit layer 162 in the first metal interconnect layer 114 is coupled to the first Si substrate 112 through the via 164; and the circuit layer 162 in the second metal interconnect layer 134 is coupled to the second Si substrate 132 through the via 164. When there are a plurality of circuit layers 162, the plurality of circuit layers 162 are interconnected to each other through the via 162, and a top-layer circuit near the top of the die in the plurality of circuit layers 162 is interconnected to the TDV 150 in the filling dielectric 140 through the via 162. Generally, an aperture of the via 162 is much smaller than an aperture of the TDV 150 in the filling dielectric layer 140. The aperture of the via 162 is about tens of nm. In this embodiment of the present invention, the plurality of circuit layers 162 may be a circuit with a specific function, or may be only a metal line used as a signal transmission path.

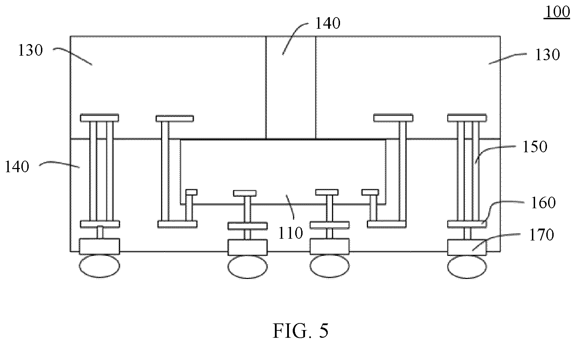

The foregoing embodiments provide solutions in which the chip 100 includes two dies. In actual application, the chip 100 may be packaged with more than two dies. For example, the chip 100 in FIG. 4 includes two first dies 110 and one second die 130. The two first dies 110 are disposed at a bottom of the second die 130, and are separately coupled to the second die 130 or the pad 170 through different TDVs 150. The two first dies 110 may carry different circuits and are used to implement different functions. For another example, the chip 100 in FIG. 5 includes one first die 110 and two second dies 130. The first die 110 spans bottoms of the two second dies 130. The two dies 130 may be spaced from each other by a filling dielectric 140 shown in FIG. 5. However, to reduce the plane area of the entire chip 100, the two second dies 130 may be as close as possible, or even the two second dies 130 may be directly attached together. More first dies or second dies are disposed in the chip 100 for various combinations, so that various circuits required in the chip 100 can be allocated to different dies based on different requirements. Therefore, the chip 100 has different manufacture precision, voltage ranges, and power consumption and heat dissipation conditions, and can flexibly cope with various situations.

The foregoing embodiments are merely intended for describing the technical solutions of the present invention, but not for limiting the present invention. Although the present invention is described in detail with reference to the foregoing embodiments, persons of ordinary skill in the art should understand that they may still make modifications to the technical solutions described in the foregoing embodiments or make equivalent replacements to some technical features thereof, without departing from the spirit and scope of the technical solutions of the embodiments of the present invention.

## Claims

1. A chip, comprising:
a first die and a second die, wherein the second die is disposed on the first die;
a filling dielectric layer is further disposed in the chip; and
a through dielectric via and an interconnection metal are disposed in the filling dielectric layer, and the first die is coupled to the second die through the through dielectric via and the interconnection metal.

2. The chip according to claim 1, wherein a top of the second die is fastened to a bottom of the first die.

3. The chip according to claim 2, wherein the chip further comprises a pad, the pad is disposed at a bottom of the chip, and the first die is located between the second die and the pad.

4. The chip according to any one of claims 1 to 3, wherein power consumption of the first die is higher than power consumption of the second die.

5. The chip according to any one of claims 1 to 4, wherein manufacture precision of the first die is different from manufacture precision of the second die.

6. The chip according to any one of claims 1 to 5, wherein the first die is used to carry a processor circuit, and the second die is used to carry an output/output circuit or an analog circuit.

7. The chip according to any one of claims 1 to 6, wherein the chip comprises at least two second dies or at least two first dies.

8. The chip according to any one of claims 1 to 7, wherein the through dielectric via comprises a first through dielectric via and a second through dielectric via, the first through dielectric via is used to connect the first die and the interconnection metal, the second through dielectric via is used to connect the second die and the interconnection metal, and the first through dielectric via and the second through dielectric via are coupled through the interconnection metal.

9. The chip according to any one of claims 1 to 8, wherein the first die comprises a first Si substrate and a first metal interconnect layer, and the second die comprises a second Si substrate and a second metal interconnect layer.

10. The chip according to claim 9, wherein a circuit layer wrapped by an insulating dielectric is disposed in each of the first metal interconnect layer and the second metal interconnect layer, a via is disposed in the insulating dielectric, the circuit layer in the first metal interconnect layer is coupled to the first Si substrate or the through dielectric via through the via, and the circuit layer in the second metal interconnect layer is coupled to the second Si substrate or the through dielectric via through the via.

11. The chip according to claim 10, wherein the first metal interconnect layer or the second metal interconnect layer comprises at least two circuit layers, and the at least two circuit layers are coupled through the via.

12. The chip according to any one of claims 1 to 10, wherein a filling dielectric in the filling dielectric layer wraps the first die and/or the second die.
